# EUROPEAN PATENT APPLICATION

(11) **EP 2 477 334 A1**
(43) Date of publication of application: **18.07.2012**
(21) Application number: 10814964.2
(22) Date of filing: 11.08.2010
(51) Int. Cl.: H03M 13/11, H04L 1/00

(54) **CONFIGURATION METHOD OF LDPC CODE CHECK MATRIX AND ENCODING METHOD AND ENCODING APPARATUS BASED ON THE CONFIGURATION METHOD**

(30) Priority: 11.09.2009 CN 200910092565
(71) Applicant: Timi Technologies Co., Ltd., Beijing 100097 (CN)
(72) Inventor: LIU, Binbin, Beijing 100097 (CN); BAI, Dong, Beijing 100097 (CN); GE, Qihong, Beijing 100097 (CN); TAO, Tao, Beijing 100097 (CN); WANG, Junwei, Beijing 100097 (CN); CHEN, Wen, Beijing 100097 (CN); JIANG, Hongqi, Beijing 100097 (CN)
(74) Representative: Donné, Eddy
(86) International application number: PCT/CN2010/075867
(87) International publication number: WO 2011/029362

(57) **Abstract**

The embodiments of the present invention provide a method of constructing parity-check matrix of LDPC code using a processor. The method comprises the following steps of: using the processor to construct a M_{B} × N_{B} base matrix B for an LDPC code with code rate R and code length N, wherein M_{B} = M / K, N_{B} = N / K, M = N (1-R), K is the expansion factor of the base matrix, K ∈ Φ, and Φ is the set of the common factors of M and N; and using the processor to replace the elements of the base matrix B with a K × K matrix, and expand the base matrix B into a parity-check matrix H with size of M × N for the encoding or decoding of the LDPC code. An encoding method and apparatus of LDPC code are also provided by the embodiments of the present invention. The technical solutions provided by the embodiments of the present invention can construct LDPC codes with good performance, solve the storage problem of the parity-check matrix, and effectively reduce the implementation complexity of the encoding apparatus.

## Description

### FIELD OF THE INVENTION

The present invention relates to wireless communication, and more particularly, to a method of constructing parity-check matrix of LDPC (Low Density Parity Check) code and an encoding method and an encoding apparatus of the LDPC code.

### BACKGROUND OF THE INVENTION

Shannon stated that the way achieving reliable transmission in a noisy channel is coding in the famous <*A Mathematical Theory of Communication>*. He presented the maximum information transmission rate of the channel, i.e. channel capacity, and deduces the minimum signal-to-noise ratio for error-free transmission, i.e. Shannon limit. The Shannon's channel coding theory provides the theoretical limit performance of coding rather than the specific channel code. Based on these, people have been working for finding out a channel code with performance close to the Shannon limit.

An LDPC code, first introduced by Gallager, is a linear block code with a very sparse parity-check matrix in which only a small quantity of non-'0' elements exist (for a binary code, the non-'0' element is '1' element). Further research by Mackay, etc. indicated that the performance of LDPC codes can be approach to the Shannon limit under the message passing (MP) decoding algorithm.

Currently, LDPC codes are more and more applied to various communication systems. The China Mobile Multimedia Broadcasting (CMMB) system adopts the channel coding of LDPC codes. The CMMB system realizes the large-area broadcasting coverage by satellite and terrestrial base stations, and provides multiple audio/video services. The user can use a handheld terminal to realize mobile receiving. As the power of the satellite signal is limited, and the path loss over the 36000 kilometers downlink distance is serious, so that the link margin at receiving terminal is very small. Therefore, an LDPC code with good performance is needed. Furthermore, the practical communication system needs encoding apparatus/decoding apparatus with low complexity. A computer searching method can generate the random or pseudo-random LDPC code with good performance, however, the random LDPC code needs a mass of storage due to the randomness of the parity-check matrix. As the long code length of the LDPC code, the encoding apparatus is very complex.

Therefore, there is a need to provide a technical solution in which LDPC codes with good performance can be constructed, the storage problem of the parity-check matrix can be solved, and the implementation complexity of the encoding apparatus can be effectively reduced.

### SUMMARY OF THE INVENTION

The present invention aims at solving at least one of the technical problems, particularly constructing parity-check matrix of LDPC code with good performance, solving the storage problem of the parity-check matrix, and effectively reducing the implementation complexity of the encoding apparatus.

In order to achieve the aims, in one aspect, the present invention provides a method of constructing parity-check matrix of LDPC code using a processor, comprising the following steps of: using the processor to construct a M_{B} × N_{B} base matrix B for an LDPC code with code rate R and code length N, wherein M_{B}= M / K, N_{B} = N / K, M = N (1-R), K is the expansion factor of the base matrix, K ∈ Φ, and Φ is the set of the common factors of M and N; and using the processor to replace the elements in the base matrix B with a K × K matrix, and expand the base matrix B into a parity-check matrix H with size of M × N for the encoding or decoding of the LDPC code.

In another aspect, the present invention further provides an encoding method of the LDPC code using a processor, comprising the following steps of:
using the processor to divide the parity-check matrix H into two submatrixes H = [Hm Hp], wherein Hm is a submatrix with size of M × (N-M) and Hp is a submatrix with size of M × M, and computing Hp⁻¹ and Hp⁻¹Hm, wherein the parity-check matrix H is constructed by the following steps of: constructing a M_{B} × N_{B} base matrix B for an LDPC code with code rate R and code length N, M_{B} = M / K, N_{B} = N / K, M = N (1-R), K is the expansion factor of the base matrix, K ∈ Φ, and Φ is the set of the common factors of M and N, selecting the number of '1' in each row and each column of the base matrix B, so that the row weight distribution and the column weight distribution of B meet a preset node degree distribution, selecting the position of '1' in each row and each column in the base matrix B, so that the M_{B} × M_{B} submatrix composed of the right M_{B} columns of B is full rank, expanding the base matrix B into a parity-check matrix H with size of M × N, replacing '0' in the base matrix B with a K × K all-'0' matrix Z, replacing '1' in the base matrix B with a K × K circulant permutation matrix P, wherein the row number i and the column number j of '1' in P meet j = (i+k) mod k, k is the offset of the circulant permutation matrix, mod indicates the modulo operation, and selecting an offset for each circulant permutation matrix P; using the processor to compute the 1 × M parity-check sequence p = m(Hp⁻¹Hm) ^{T} according to the input 1 × (N-M) information sequence m; and combining the information sequence m with the parity-check sequence p into the 1 × N code word sequence c = [m p], and outputting the same.

In another aspect, the present invention further provides an encoding apparatus of the LDPC code, comprising an encoding matrix storing module, a parity-check sequence computing module and a code word sequence generating module.

The encoding matrix storing module is used for storing the structure of the encoding matrix, dividing the parity-check matrix H with size of M × N into two submatrixes H = [Hm Hp], wherein Hm is a submatrix with size of M × (N-M) and Hp is a submatrix with size of M × M, the encoding matrix storing module is used for storing the structure of the matrix Hp⁻¹Hm, wherein the Hp⁻¹Hm has the block circulant structure and can be stored in the form of block, and the parity-check matrix H is constructed by the following steps of: constructing a M_{B} × N_{B} base matrix B for an LDPC code with code rate R and code length N, wherein M_{B} = M / K, N_{B}= N / K, M = N (1-R), K is the expansion factor of the base matrix, K ∈ Φ, and Φ is the set of the common factors of M and N, selecting the number of '1' in each row and each column of the base matrix B, so that the row weight distribution and the column weight distribution of B meet a preset node degree distribution, selecting the position of '1' in each row and each column in the base matrix B , so that the M_{B} × M_{B} submatrix composed of the right M_{B} columns of B is full rank, expanding the base matrix B into a parity-check matrix H with size of M × N, replacing '0' in the base matrix B with a K × K all-'0' matrix Z, replacing '1' in the base matrix B with a K × K circulant permutation matrix P, wherein the row number i and the column number j of '1' in P meet j = (i+k) mod k, k is the offset of the circulant permutation matrix, mod indicates the modulo operation, and selecting an offset for each K × K circulant permutation matrix P; the parity-check sequence computing module is used for multiplying the input information sequence m by the matrix (Hp⁻¹Hm) ^{T} to obtain the parity-check sequence p; and the code word sequence generating module is used for combining the information sequence m with the parity-check sequence p into the code word sequence c = [m p], and outputting the same.

The technical solutions of the present invention can construct LDPC codes with good performance. Furthermore, the technical solutions of the present invention also solve the storage problem of the parity-check matrix, and effectively reduce the complexity of the encoding apparatus. The LDPC code constructed by the technical solutions of the present invention can be completely compatible with the physical layer of the CMMB system, so that the link margin of the system can be effectively improved.

The further aspects and advantages of the present invention will be described in the following description, and some aspects and advantages will be more apparent from the following description or will be known through the practice of the present invention.

### BRIEF DESCRIPTION OF THE DRAWINGS

The above and/or further aspects and advantages will be more apparent from the following description of embodiments with reference to the figures, in which:
Fig. 1 is a flow diagram showing a method of constructing parity-check matrix of LDPC code according to the embodiment of the present invention.
Fig. 2 is a schematic diagram showing a base matrix according to the embodiments of the present invention.
Fig. 3 is a schematic diagram showing the performance curve of the LDPC code according to the embodiments of the present invention.
Fig. 4 is a schematic diagram showing the structure of an encoding apparatus according to the embodiments of the present invention.

### DETAILED DESCRIPTION OF PREFERRED EMBODIMENTS

The embodiments of the present invention will be detailed in the following. The exemplary embodiments are illustrated in the figures, throughout which the same or similar reference numerals refer to the same or similar elements or to elements having the same or similar functions. The following embodiments described with reference to the figures are exemplary only for explaining, rather than limiting the present invention.

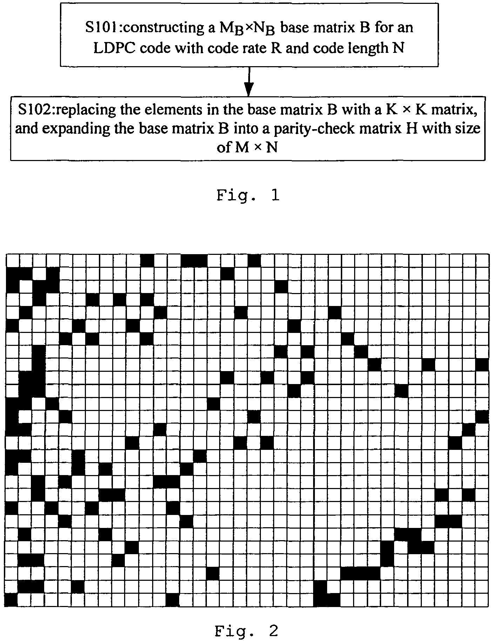

In order to achieve the aims of the present invention, the embodiments of the present invention provide a method of constructing parity-check matrix of LDPC code using a processor, as shown in Fig. 1, comprising the following steps of:
S101: constructing a M_{B} × N_{B} base matrix B for an LDPC code with code rate R and code length N, wherein M_{B} = M / K, N_{B} = N / K, M = N (1-R), K is the expansion factor of the base matrix, K ∈ Φ, and Φ is the set of the common factors of M and N.

Specifically, the step of constructing a M_{B} × N_{B} base matrix B for an LDPC code with code rate R and code length N comprises the following steps of:
Constructing a M_{B} × N_{B} base matrix B, and selecting the number of '1' in each row and each column of the base matrix B, so that the row weight distribution and the column weight distribution of B meet a preset node degree distribution of the LDPC code ensemble with good performance; and

Selecting the position of '1' in each row and each column of B, so that the M_{B} × M_{B} submatrix composed of the right M_{B} columns of B is full rank.

The structure of the base matrix B can be stored in the form of table, the position of '1' in each row of B are recorded in each row of the table. The order of the row can be arbitrary, and the constructed matrixes B are equivalent.

S102: replacing the elements in the base matrix B with a K × K matrix, and expanding the base matrix B into a parity-check matrix H with size of M × N.

Specifically, the step of expanding the base matrix B into a parity-check matrix H with size of M × N comprises the following steps of:
Replacing '0' in the base matrix B with a K × K all-'0' matrix Z, and replacing '1' in the base matrix B with a K × K circulant permutation matrix P to obtain the parity-check matrix H, wherein the row number i and the column number j of '1' in P meet j = (i+k) mod k, k is the offset of the circulant permutation matrix, and mod indicates the modulo operation; and

Selecting an offset for each K × K circulant permutation matrix P.

The offset of the circulant permutation matrix P can be stored in the form of table, wherein the offsets of the circulant permutation matrix P which correspond to '1' in each row of the base matrix B are recorded in each row of the table. If the offset at the same row are added by an offset q, i.e. k' = (k+q) mod K, the constructed matrixes H are equivalent.

Therefore, the structure of the parity-check matrix H can be stored in the form of the base matrix position table and the circulant permutation matrix offset table, so that the storage problem of the parity-check matrix is solved.

The embodiments of the present invention further provide an encoding method of the LDPC code, comprising the following steps of:
Dividing the parity-check matrix H with size of M × N into two submatrixes H = [Hm Hp], wherein Hm is the submatrix with size of M × (N-M) and Hp is a submatrix with size of M × M, and computing Hp⁻¹ and Hp⁻¹Hm;
Computing the 1 × M dimensional parity-check sequence p = m(Hp⁻¹Hm) ^{T} according to the input 1 × (N-M) information sequence m; and
Combining the information sequence m with the parity-check sequence p into the 1 × N code word sequence c = [m p], and outputting the same.
In order to illustrate the present invention, the embodiments are introduced with reference to the physical layer of the CMMB system.

### Embodiment 1:

Constructing an LDPC code with code rate 1/4 applying to the CMMB system.

In order to be compatible with the physical layer of the CMMB system, selecting the code length N to be 9216, i.e. further constructing a 6912 × 9216 parity-check matrix H. In order to be compatible with the LDPC code with code rate 1/2 and 3/4 in the CMMB system, selecting the expansion factor K to be 256. Therefore, the size of the base matrix B is 27 × 36.

Selecting the row weight and the column weigh of the base matrix B. Preferably, the row weight distribution of B is {lambda 5, lambda 4} = {2/27, 25/27}, and the column weight distribution is {rho 10, rho 4, rho 3, rho 2} = {3/36, 3/36, 8/36, 22/36}. In the condition that the row weight distribution and the column weight distribution are met, selecting the position of '1' in each row and each column of the base matrix B, so that the 27 × 27 submatrix composed of the right 27 columns of B is full rank, and the short cycle in B is avoided.

A base matrix position table generated according to the method is as follows:

| | | | | |
|---|---|---|---|---|
| 10, | 13, | 14, | 18, | |
| 0, | 1, | 3, | 16, | |
| 0, | 2, | 3, | 20, | |
| 2, | 6, | 8, | 10, | |
| 1, | 11, | 17, | 24, | |
| 0, | 5, | 9, | 21, | |
| 4, | 6, | 10, | 25, | |
| 2, | 20, | 22, | 26, | |
| 2, | 27, | 31, | 35, | |
| 1, | 2, | 16, | 19, | 22, |
| 1, | 2, | 21, | 29, | |
| 0, | 1, | 3, | 15, | |
| 0, | 4, | 18, | 35, | |
| 0, | 1, | 11, | 34, | |
| 9, | 17, | 19, | 33, | |
| 0, | 1, | 5, | 14, | |
| 0, | 5, | 7, | 13, | |
| 2, | 4, | 11, | 12, | |
| 2, | 7, | 8, | 32, | 34, |
| 0, | 3, | 6, | 12, | |
| 4, | 13, | 32, | 33, | |
| 1, | 7, | 29, | 30, | |
| 9, | 28, | 30, | 31, | |
| 1, | 2, | 8, | 28, | |
| 15, | 25, | 26, | 27, | |
| 1, | 2, | 5, | 23, | |
| 0, | 12, | 23, | 24. | |

The corresponding base matrix is as shown in Fig. 2, wherein the black blocks show the elements '1', and the white blocks show the elements '0'.

Replacing '0' in the base matrix B with a 256 × 256 all- '0' matrix Z, and replacing '1' in the base matrix B with a 256 × 256 circulant permutation matrix P to obtain the parity-check matrix H, wherein the row number i and the column number j of '1' in P meet j = (i+k) mod 256, k is the offset of the circulant permutation matrix, and mod indicates the modulo operation.

Selecting the offset of each circulant permutation matrix P, so that the girth of the parity-check matrix H is further prolonged.

A circulant permutation matrix offset table generated according to the method is as follows:

| | | | | |
|---|---|---|---|---|
| 195, | 130, | 214, | 42, | |
| 79, | 98, | 59, | 149, | |
| 157, | 72, | 125, | 189, | |
| 150, | 252, | 7, | 227, | |
| 76, | 187, | 217, | 32, | |
| 110, | 225, | 111, | 113, | |
| 104, | 84, | 100, | 81, | |
| 161, | 47, | 248, | 97, | |
| 135, | 96, | 51, | 158, | |
| 242, | 147, | 54, | 178, | 145, |
| 202, | 74, | 175, | 236, | |
| 235, | 129, | 128, | 128, | |
| 194, | 44, | 247, | 130, | |
| 109, | 76, | 36, | 184, | |
| 129, | 155, | 248, | 222, | |
| 10, | 161, | 6, | 81, | |
| 73, | 44, | 206, | 72, | |
| 227, | 92, | 39, | 90, | |
| 113, | 50, | 160, | 190, | 12, |
| 7, | 202, | 178, | 167, | |
| 228, | 2, | 83, | 7, | |
| 115, | 119, | 180, | 171, | |
| 145, | 165, | 196, | 41, | |
| 47, | 133, | 75, | 3, | |
| 16, | 89, | 90, | 138, | |
| 253, | 57, | 198, | 130, | |
| 182, | 166, | 172, | 180. | |

The encoding method of the LDPC code based on the method of constructing the parity-check matrix comprises the following steps of:
   Dividing the parity-check matrix H with size of 6912 × 6912 into two submatrixes H = [Hm Hp], wherein Hm is a submatrix with size of 6912 × 2304 and Hp is a submatrix with size of 6912 × 6912,
   and computing Hp⁻¹ and Hp⁻¹Hm, wherein Hp⁻¹Hm has the block circulant structure, i.e. can be divided into 27 × 9 circulant submatrixes with size of 256 × 256;

Computing the 1 × 6912 parity-check sequence p = m(Hp⁻¹-Hm)^{T} according to the input 1 × 2304 information sequence m; and

Combining the information sequence m with the parity-check sequence p into the 1 × 9216 code word sequence c = [m p], and outputting the same.

The encoding apparatus for implementing the encoding method comprises an encoding matrix storing module, a parity-check sequence computing module and a code word sequence generating module.

The encoding matrix storing module is used for storing the structure of the matrix Hp⁻¹Hm in the form of block since the Hp⁻¹Hm has the block circulant structure, so that the storage resources can be greatly reduced;

The parity-check sequence computing module is used for multiplying the input information sequence m by the matrix (Hp⁻¹Hm) ^{T} to obtain the parity-check sequence p; and as the Hp⁻¹Hm has the block circulant structure, the matrix multiplication m(Hp⁻¹Hm)^{T} can be implemented with simple shift registers, so that the implementation complexity of the encoding apparatus is greatly reduced; and

The code word sequence generating module is used for combining the information sequence m with the parity-check sequence p into the code word sequence c, and outputting the same.

### Embodiment 2:

Constructing an LDPC code with code rate 1/3 applying to the CMMB system.

In order to be compatible with the physical layer of the CMMB system, selecting the code length N to be 9216, i.e. further constructing a parity-check matrix H with size of 6144 × 9216. In order to be compatible with the LDPC code with code rate 1/2 and 3/4 in the CMMB system, selecting the expansion factor K to be 256. Therefore, the size of the base matrix B is 24 × 36.

Selecting the row weight and the column weigh of the base matrix B. Preferably, the row weight distribution of B is {lambda 5} = {24/27}, and the column weight distribution is {rho 10, rho 3, rho 2} = {4/36, 16/36, 16/36}.

In the condition that the row weight distribution and the column weight distribution are met, selecting the position of '1' in each row and each column of the base matrix B, so that the 24 × 24 submatrix composed of the right 24 columns of B is full rank, and the short cycle in B is avoided.

A base matrix position table generated according to the method is as follows:

| | | | | |
|---|---|---|---|---|
| 1, | 8, | 11, | 29, | 32, |
| 2, | 3, | 9, | 28, | 32, |
| 1, | 2, | 3, | 4, | 23, |
| 0, | 3, | 17, | 24, | 27, |
| 1, | 3, | 10, | 15, | 22, |
| 0, | 1, | 2, | 5, | 19, |
| 2, | 6, | 9, | 19, | 21, |
| 0, | 3, | 10, | 11, | 14, |
| 0, | 3, | 14, | 16, | 18, |
| 0, | 3, | 5, | 12, | 16, |
| 0, | 3, | 6, | 11, | 12, |
| 2, | 12, | 27, | 33, | 35, |
| 2, | 15, | 24, | 26, | 29, |
| 7, | 9, | 21, | 25, | 28, |
| 1, | 3, | 14, | 25, | 34, |
| 7, | 15, | 16, | 30, | 31, |
| 0, | 10, | 17, | 22, | 23, |
| 0, | 1, | 19, | 20, | 35, |
| 2, | 3, | 6, | 18, | 34, |
| 1, | 2, | 8, | 13, | 17, |
| 1, | 4, | 7, | 13, | 20, |
| 0, | 5, | 13, | 31, | 33, |
| 1, | 2, | 4, | 8, | 26, |
| 0, | 1, | 2, | 18, | 30. |

Replacing '0' in the base matrix B with a 256 × 256 all- '0' matrix Z, and replacing '1' in the base matrix B with a 256 × 256 circulant permutation matrix P to obtain the parity-check matrix H, wherein the row number i and the column number j of '1' in P meet j = (i+k) mod 256, k is the offset of the circulant permutation matrix, and mod indicates the modulo operation.

Selecting the offset of each circulant permutation matrix P, so that the girth of the parity-check matrix H is further prolonged.

A circulant permutation matrix offset table generated according to the method is as follows:

| | | | | |
|---|---|---|---|---|
| 64, | 14, | 11, | 157, | 147, |
| 167, | 61, | 158, | 108, | 147, |
| 81, | 197, | 208, | 2, | 93, |
| 188, | 90, | 198, | 100, | 233, |
| 153, | 165, | 230, | 66, | 91, |
| 17, | 144, | 195, | 150, | 193, |
| 220, | 57, | 145, | 223, | 91, |
| 111, | 133, | 57, | 145, | 108, |
| 153, | 171, | 165, | 142, | 14, |
| 195, | 67, | 219, | 209, | 202, |
| 129, | 187, | 165, | 37, | 122, |
| 147, | 99, | 111, | 218, | 249, |
| 71, | 232, | 15, | 7, | 134, |
| 113, | 166, | 211, | 210, | 26, |
| 1, | 247, | 141, | 168, | 78, |
| 88, | 18, | 175, | 165, | 117, |
| 121, | 225, | 2, | 43, | 197, |
| 188, | 214, | 81, | 160, | 62, |
| 126, | 195, | 123, | 80, | 65, |
| 212, | 186, | 93, | 184, | 179, |
| 250, | 84, | 38, | 217, | 22, |
| 181, | 240, | 169, | 68, | 106, |
| 239, | 73, | 214, | 234, | 8, |
| 71, | 13, | 176, | 82, | 127. |

The encoding method of the LDPC code based on the method of constructing the parity-check matrix comprises the following steps of:
Dividing the parity-check matrix H with size of 6144 × 9216 into two submatrixes H = [Hm Hp], wherein Hm is a submatrix with size of 6144 × 3072 and Hp is a submatrix with size of 6144 × 6144, and computing Hp⁻¹ and Hp⁻¹Hm, wherein Hp⁻¹Hm has the block circulant structure, i.e. can be divided into 24 × 12 of circulant submatrixes with size of 256 × 256;

Computing the 1 × 6144 parity-check sequence p = m(Hp⁻¹Hm)^{T} according to the input 1 × 3072 information sequence m; and

Combining the information sequence m with the parity-check sequence p into the 1 × 9216 code word sequence c = [m p], and outputting the same.

A encoding apparatus for implementing the encoding method comprises an encoding matrix storing module, a parity-check sequence computing module and a code word sequence generating module, wherein

The encoding matrix storing module is used for storing the structure of the matrix Hp⁻¹Hm in the form of block since the Hp⁻¹Hm has the block circulant structure, so that the storage resources can be greatly reduced;

The parity-check sequence computing module is used for multiplying the input information sequence m by the matrix (Hp⁻¹Hm) ^{T} to obtain the parity-check sequence p; and as the Hp⁻¹Hm has the block circulant structure, the matrix multiplication m(Hp⁻¹-Hm)^{T} can be implemented with simple shift registers, so that the implementation complexity of the encoding apparatus is greatly reduced; and

The code word sequence generating module is used for combining the information sequence m with the parity-check sequence p into the code word sequence c, and outputting the same.

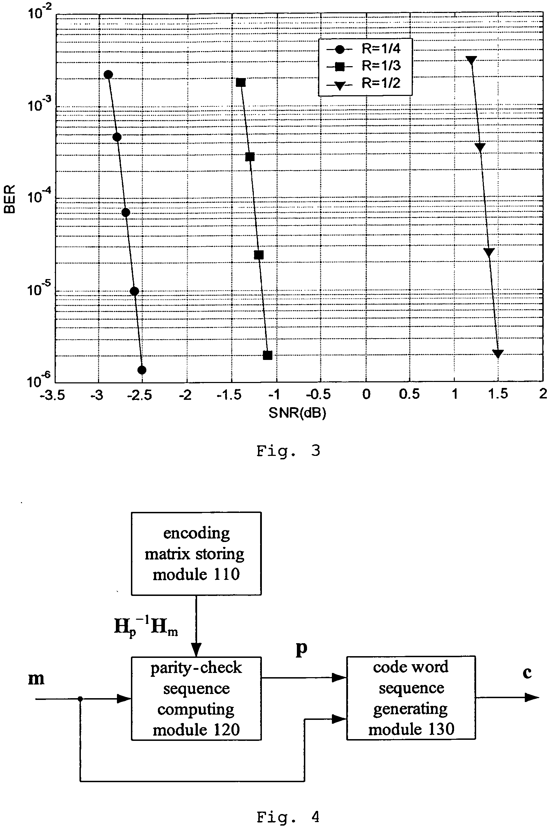

The performance curve of the LDPC code with code rate 1/4 and 1/3 constructed in the two embodiments and the performance comparison with the LDPC code with code rate 1/2 are as shown in Fig. 3. According to the Shannon's channel coding theory, the signal to noise ratio (SNR) limit at code rate 1/4 is about -3.5dB. As shown in Fig. 3, for the LDPC code with code rate 1/4 constructed in the embodiment 1, the SNR is about -2.5dB when the bit error rate (BER) reaches 10⁻⁶ and is approach to the theoretical limit performance. Compared with the LDPC code with code rate 1/2, the gain is about 4dB, so that the link margin of the CMMB system can be effectively improved. For the LDPC code with code rate 1/3 constructed in the embodiment 2, the similar conclusion can be drawn.

As shown in Fig. 4, the embodiment of the present invention further provides an encoding apparatus of the LDPC code, comprising an encoding matrix storing module 110, a parity-check sequence computing module 120 and a code word sequence generating module 130.

The encoding matrix storing module 110 is used for storing the structure of the encoding matrix, dividing the parity-check matrix H with size of M × N into two submatrixes H = [Hm Hp], wherein Hm is a submatrix with size of M × (N-M) and Hp is a submatrix with size of M × M. The encoding matrix storing module 110 is used for storing the structure of matrix Hp⁻¹Hm in the form of block, since the Hp⁻¹Hm has the block circulant structure, so that the storage resources can be greatly reduced. The parity-check matrix H is constructed by the following steps of: constructing a M_{B} × N_{B} base matrix B for an LDPC code with code rate R and code length N, wherein M_{B} = M / K, N_{B} = N / K, M = N (1-R), K is the expansion factor of the base matrix, K ∈ Φ, and Φ is the set of the common factors of M and N; selecting the number of '1' in each row and each column of the base matrix B, so that the row weight distribution and the column weight distribution of B meet a preset node degree distribution; selecting the position of '1' in each row and each column in the base matrix B, so that the M_{B} × M_{B} submatrix compose of the right M_{B} columns of B is full rank; expanding the base matrix B into a parity-check matrix H with size of M × N, replacing '0' in the base matrix B with a K × K all- '0' matrix Z, replacing '1' in the base matrix B with a K × K dimensional circulant permutation matrix P, wherein the row number i and the column number j of '1' in P meet j = (i+k) mod k, k is the offset of the circulant permutation matrix, mod indicates the modulo operation, and selecting an offset for each K × K circulant permutation matrix P;

The parity-check sequence computing module 120 is used for multiplying the input information sequence m by the matrix (Hp⁻¹Hm) ^{T} to obtain the parity-check sequence p; and as the Hp⁻¹Hm has the block circulant structure, the matrix multiplication m(Hp-¹Hm)^{T} can be implemented with simple shift registers, so that the implementation complexity of the encoding apparatus is greatly reduced; and

The code word sequence generating module 130 is used for combining the information sequence m with the parity-check sequence p into the code word sequence c, and outputting the same.

Taken as an embodiment of the encoding apparatus, the parity-check matrix H is constructed by expanding a 27 × 36 base matrix B:
The position of '1' in the base matrix B is specifically as follows:

| | | | | |
|---|---|---|---|---|
| 10, | 13, | 14, | 18, | |
| 0, | 1, | 3, | 16, | |
| 0, | 2, | 3, | 20, | |
| 2, | 6, | 8, | 10, | |
| 1, | 11, | 17, | 24, | |
| 0, | 5, | 9, | 21, | |
| 4, | 6, | 10, | 25, | |
| 2, | 20, | 22, | 26, | |
| 2, | 27, | 31, | 35, | |
| 1, | 2, | 16, | 19, | 22, |
| 1, | 2, | 21, | 29, | |
| 0, | 1, | 3, | 15, | |
| 0, | 4, | 18, | 35, | |
| 0, | 1, | 11, | 34, | |
| 9, | 17, | 19, | 33, | |
| 0, | 1, | 5, | 14, | |
| 0, | 5, | 7, | 13, | |
| 2, | 4, | 11, | 12, | |
| 2, | 7, | 8, | 32, | 34, |
| 0, | 3, | 6, | 12, | |
| 4, | 13, | 32, | 33, | |
| 1, | 7, | 29, | 30, | |
| 9, | 28, | 30, | 31, | |
| 1, | 2, | 8, | 28, | |
| 15, | 25, | 26, | 27, | |
| 1, | 2, | 5, | 23, | |
| 0, | 12, | 23, | 24; | |

The steps of expanding the base matrix B into the 6912 × 9216 parity-check matrix H comprise the following steps of:
Replacing '0' in the base matrix B with a 256 × 256 all- '0' matrix Z, and replacing '1' in the base matrix B with a 256 × 256 circulant permutation matrix P, wherein the row number i and the column number j of '1' in P meet j = (i+k) mod 256, k is the offset of the circulant permutation matrix, mod indicates the modulo operation, and the offset of the circulant permutation matrix P is specifically as follows:

| | | | | |
|---|---|---|---|---|
| 195, | 130, | 214, | 42, | |
| 79, | 98, | 59, | 149, | |
| 157, | 72, | 125, | 189, | |
| 150, | 252, | 7, | 227, | |
| 76, | 187, | 217, | 32, | |
| 110, | 225, | 111, | 113, | |
| 104, | 84, | 100, | 81, | |
| 161, | 47, | 248, | 97, | |
| 135, | 96, | 51, | 158, | |
| 242, | 147, | 54, | 178, | 145, |
| 202, | 74, | 175, | 236, | |
| 235, | 129, | 128, | 128, | |
| 194, | 44, | 247, | 130, | |
| 109, | 76, | 36, | 184, | |
| 129, | 155, | 248, | 222, | |
| 10, | 161, | 6, | 81, | |
| 73, | 44, | 206, | 72, | |
| 227, | 92, | 39, | 90, | |
| 113, | 50, | 160, | 190, | 12, |
| 7, | 202, | 178, | 167, | |
| 228, | 2, | 83, | 7, | |
| 115, | 119, | 180, | 171, | |
| 145, | 165, | 196, | 41, | |
| 47, | 133, | 75, | 3, | |
| 16, | 89, | 90, | 138, | |
| 253, | 57, | 198, | 130, | |
| 182, | 166, | 172, | 180; | |

Dividing the parity-check matrix H into two submatrixes H = [Hm Hp], wherein Hm is the submatrix with size of 6912 × 2304 and Hp is a submatrix with size of 6912 × 6912. Taken as an embodiment of the encoding apparatus, the parity-check matrix H is constructed by expanding a 24 × 36 base matrix B:
The position of '1' in the base matrix B is specifically as follows:

| | | | | |
|---|---|---|---|---|
| 1, | 8, | 11, | 29, | 32, |
| 2, | 3, | 9, | 28, | 32, |
| 1, | 2, | 3, | 4, | 23, |
| 0, | 3, | 17, | 24, | 27, |
| 1, | 3, | 10, | 15, | 22, |
| 0, | 1, | 2, | 5, | 19, |
| 2, | 6, | 9, | 19, | 21, |
| 0, | 3, | 10, | 11, | 14, |
| 0, | 3, | 14, | 16, | 18, |
| 0, | 3, | 5, | 12, | 16, |
| 0, | 3, | 6, | 11, | 12, |
| 2, | 12, | 27, | 33, | 35, |
| 2, | 15, | 24, | 26, | 29, |
| 7, | 9, | 21, | 25, | 28, |
| 1, | 3, | 14, | 25, | 34, |
| 7, | 15, | 16, | 30, | 31, |
| 0, | 10, | 17, | 22, | 23, |
| 0, | 1, | 19, | 20, | 35, |
| 2, | 3, | 6, | 18, | 34, |
| 1, | 2, | 8, | 13, | 17, |
| 1, | 4, | 7, | 13, | 20, |
| 0, | 5, | 13, | 31, | 33, |
| 1, | 2, | 4, | 8, | 26, |
| 0, | 1, | 2, | 18, | 30; |

The step of expanding the base matrix B into the 6144 × 9216 parity-check matrix H comprises the following steps of:
Replacing '0' in the base matrix B with a 256 × 256 all- '0' matrix Z, and replacing '1' in the base matrix B with a 256 × 256 circulant permutation matrix P, wherein the row number i and the column number j of '1' in P meet j = (i+k) mod 256, k is the offset of the circulant permutation matrix, mod indicates the modulo operation, and the offset of the circulant permutation matrix P is specifically as follows:

| | | | | |
|---|---|---|---|---|
| 64, | 14, | 11, | 157, | 147, |
| 167, | 61, | 158, | 108, | 147, |
| 81, | 197, | 208, | 2, | 93, |
| 188, | 90, | 198, | 100, | 233, |
| 153, | 165, | 230, | 66, | 91, |
| 17, | 144, | 195, | 150, | 193, |
| 220, | 57, | 145, | 223, | 91, |
| 111, | 133, | 57, | 145, | 108, |
| 153, | 171, | 165, | 142, | 14, |
| 195, | 67, | 219, | 209, | 202, |
| 129, | 187, | 165, | 37, | 122, |
| 147, | 99, | 111, | 218, | 249, |
| 71, | 232, | 15, | 7, | 134, |
| 113, | 166, | 211, | 210, | 26, |
| 1, | 247, | 141, | 168, | 78, |
| 88, | 18, | 175, | 165, | 117, |
| 121, | 225, | 2, | 43, | 197, |
| 188, | 214, | 81, | 160, | 62, |
| 126, | 195, | 123, | 80, | 65, |
| 212, | 186, | 93, | 184, | 179, |
| 250, | 84, | 38, | 217, | 22, |
| 181, | 240, | 169, | 68, | 106, |
| 239, | 73, | 214, | 234, | 8, |
| 71, | 13, | 176, | 82, | 127; |

Dividing the parity-check matrix H into two submatrixes H = [Hm Hp], wherein Hm is a submatrix with size of 6144 × 3072 and Hp is a submatrix with size of 6144 × 6144.

The technical solutions provided by the embodiments of the present invention can construct LDPC codes with good performance. Furthermore, the technical solutions provided by the embodiments of the present invention also solve the storage problem of the parity-check matrix, and effectively reduce the implementation complexity of the encoding apparatus. The LDPC codes constructed by the technical solutions provided by the embodiments of the present invention can be completely compatible with the physical layer of the CMMB system, so that the link margin of the system can be effectively improved.

The person skilled in the art can know that all or some steps for implementing the method of the embodiments can be completed by the means that correlative hardware is instructed by a program, wherein the program can be stored in a readable storage medium of the computer, and the execution of the program comprises at least one step of the method in the embodiments or the combination thereof.

Furthermore, each functional unit in embodiments of the present invention can be integrated into one processing module, or be independently and physically existed, or at least two of the units are integrated into one module. The mentioned integrated module not only can be implemented in hardware but also in software function module. If the integrated module is implemented in the manner of the software function module and is sold or used as an independent product, the integrated module also can be stored in the readable storage medium of the computer.

The said storage medium can be a read-only storage, a magnetic disc or an optical disc, etc.

The disclosed content only is the preferable embodiments of the present invention, it should be pointed out that various improvements and modifications can be made to the embodiments by those skilled in the art without departing from the principle of the present invention, and the improvements and modifications also belong to the protection scope of the present invention.

## Claims

1. A method of constructing parity-check matrix of LDPC code using a processor, comprising the following steps of:
using the processor to construct a M_{B} × N_{B} base matrix B for an LDPC code with code rate R and code length N, wherein M_{B} = M / K, NB= N / K, M = N (1-R), K is the expansion factor of the base matrix, K ∈ Φ, and Φ is the set of the common factors of M and N; and using the processor to replace elements in the base matrix B with a K × K matrix, and expand the base matrix B into a parity-check matrix H with size of M × N for the encoding or decoding of the LDPC code.

2. The method of constructing parity-check matrix of LDPC code according to claim 1, wherein the step of using the processor to construct a M_{B} × N_{B} base matrix B for an LDPC code with code rate R and code length N comprises the following steps of:
constructing a M_{B} × N_{B} base matrix B, and selecting the number of '1' in each row and each column of the base matrix B, so that the row weight distribution and the column weight distribution of B meet a preset node degree distribution; and selecting the position of '1' in each row and each column of the base matrix B, so that the M_{B} × M_{B} submatrix composed of the right M_{B} columns of B is full rank.

3. The method of constructing parity-check matrix of LDPC code according to claim 2, wherein the step of using the processor to expand the base matrix B into a parity-check matrix H with size of M × N comprises the following steps of: replacing '0' in the base matrix B with a K × K all- '0' matrix Z, and replacing '1' in the base matrix B with a K × K dimensional circulant permutation matrix P, wherein the row number i and the column number j of '1' in P meet j = (i+k) mod k, k is the offset of the circulant permutation matrix, and mod indicates the modulo operation; and
selecting an offset for each K × K circulant permutation matrix P.

4. The method of constructing parity-check matrix of LDPC code according to any one of claim 2 or 3, wherein the structure of the base matrix B or the offset of the circulant permutation matrix P can be stored in the form of table, wherein each row of the table records the position of '1' in each row of the base matrix B or the offset of the circulant permutation matrix P which corresponds to '1' in each row of the base matrix B.

5. The method of constructing parity-check matrix of LDPC code according to claim 2, wherein the code rate R is 1/4, the code length N is 9216, the expansion factor K is 256, the row weight distribution of the base matrix B is {λ₅, λ₄} = {2/27, 25/27}, and the column weight distribution is {*ρ*₁₀, *ρ*₄, *ρ*₃, *ρ*₂}= {3/36, 3/36, 8/36, 22/36}.

6. The method of constructing parity-check matrix of LDPC code according to claim 5, wherein the position of '1' in the base matrix B is specifically as follows:
| | | | | |
|---|---|---|---|---|
| 10, | 13, | 14, | 18, | |
| 0, | 1, | 3, | 16, | |
| 0, | 2, | 3, | 20, | |
| 2, | 6, | 8, | 10, | |
| 1, | 11, | 17, | 24, | |
| 0, | 5, | 9, | 21, | |
| 4, | 6, | 10, | 25, | |
| 2, | 20, | 22, | 26, | |
| 2, | 27, | 31, | 35, | |
| 1, | 2, | 16, | 19, | 22, |
| 1, | 2, | 21, | 29, | |
| 0, | 1, | 3, | 15, | |
| 0, | 4, | 18, | 35, | |
| 0, | 1, | 11, | 34, | |
| 9, | 17, | 19, | 33, | |
| 0, | 1, | 5, | 14, | |
| 0, | 5, | 7, | 13, | |
| 2, | 4, | 11, | 12, | |
| 2, | 7, | 8, | 32, | 34, |
| 0, | 3, | 6, | 12, | |
| 4, | 13, | 32, | 33, | |
| 1, | 7, | 29, | 30, | |
| 9, | 28, | 30, | 31, | |
| 1, | 2, | 8, | 28, | |
| 15, | 25, | 26, | 27, | |
| 1, | 2, | 5, | 23, | |
| 0, | 12, | 23, | 24. | |

7. The method of constructing parity-check matrix of LDPC code according to claim 6, wherein the step of using the processor to expand the base matrix B into a parity-check matrix H with size of 6912 × 9216 comprises the following steps of: replacing '0' in the base matrix B with a 256 × 256 all- '0' matrix Z, and replacing '1' in the base matrix B with a 256 × 256 circulant permutation matrix P, wherein the row number i and the column number j of '1' in P meet j = (i+k) mod 256, k is the offset of the circulant permutation matrix, mod indicates the modulo operation, and the offset of the circulant permutation matrix P is specifically as follows:
| | | | | |
|---|---|---|---|---|
| 195, | 130, | 214, | 42, | |
| 79, | 98, | 59, | 149, | |
| 157, | 72, | 125, | 189, | |
| 150, | 252, | 7, | 227, | |
| 76, | 187, | 217, | 32, | |
| 110, | 225, | 111, | 113, | |
| 104, | 84, | 100, | 81, | |
| 161, | 47, | 248, | 97, | |
| 135, | 96, | 51, | 158, | |
| 242, | 147, | 54, | 178, | 145, |
| 202, | 74, | 175, | 236, | |
| 235, | 129, | 128, | 128, | |
| 194, | 44, | 247, | 130, | |
| 109, | 76, | 36, | 184, | |
| 129, | 155, | 248, | 222, | |
| 10, | 161, | 6, | 81, | |
| 73, | 44, | 206, | 72, | |
| 227, | 92, | 39, | 90, | |
| 113, | 50, | 160, | 190, | 12, |
| 7, | 202, | 178, | 167, | |
| 228, | 2, | 83, | 7, | |
| 115, | 119, | 180, | 171, | |
| 145, | 165, | 196, | 41, | |
| 47, | 133, | 75, | 3, | |
| 16, | 89, | 90, | 138, | |
| 253, | 57, | 198, | 130, | |
| 182, | 166, | 172, | 180. | |

8. The method of constructing parity-check matrix of LDPC code according to claim 2, wherein the code rate is 1/3, the code length N is 9216, the expansion factor K is 256, the row weight distribution of the base matrix B is {λ₅} = {24/24}, and the column weight distribution is {*ρ*₁₀, *ρ*₃, *ρ*₂} = {4/36, 16/36, 16/36}.

9. The method of constructing parity-check matrix of LDPC code according to claim 8, wherein the position of '1' in the base matrix B is specifically as follows:
| | | | | |
|---|---|---|---|---|
| 1, | 8, | 11, | 29, | 32, |
| 2, | 3, | 9, | 28, | 32, |
| 1, | 2, | 3, | 4, | 23, |
| 0, | 3, | 17, | 24, | 27, |
| 1, | 3, | 10, | 15, | 22, |
| 0, | 1, | 2, | 5, | 19, |
| 2, | 6, | 9, | 19, | 21, |
| 0, | 3, | 10, | 11, | 14, |
| 0, | 3, | 14, | 16, | 18, |
| 0, | 3, | 5, | 12, | 16, |
| 0, | 3, | 6, | 11, | 12, |
| 2, | 12, | 27, | 33, | 35, |
| 2, | 15, | 24, | 26, | 29, |
| 7, | 9, | 21, | 25, | 28, |
| 1, | 3, | 14, | 25, | 34, |
| 7, | 15, | 16, | 30, | 31, |
| 0, | 10, | 17, | 22, | 23, |
| 0, | 1, | 19, | 20, | 35, |
| 2, | 3, | 6, | 18, | 34, |
| 1, | 2, | 8, | 13, | 17, |
| 1, | 4, | 7, | 13, | 20, |
| 0, | 5, | 13, | 31, | 33, |
| 1, | 2, | 4, | 8, | 26, |
| 0, | 1, | 2, | 18, | 30. |

10. The method of constructing parity-check matrix of LDPC code according to claim 9, wherein the step of expanding the base matrix B into a parity-check matrix H with size of 6144 × 9216 comprises the following steps of: replacing '0' in the base matrix B with a 256 × 256 all-'0' matrix Z, and replacing '1' in the base matrix B with a 256 × 256 circulant permutation matrix P, wherein the row number i and the column number j of '1' in P meet j = (i+k) mod 256, k is the offset of the circulant permutation matrix, mod indicates the modulo operation, and the offset of the circulant permutation matrix P is specifically as follows:
| | | | | |
|---|---|---|---|---|
| 64, | 14, | 11, | 157, | 147, |
| 167, | 61, | 158, | 108, | 147, |
| 81, | 197, | 208, | 2, | 93, |
| 188, | 90, | 198, | 100, | 233, |
| 153, | 165, | 230, | 66, | 91, |
| 17, | 144, | 195, | 150, | 193, |
| 220, | 57, | 145, | 223, | 91, |
| 111, | 133, | 57, | 145, | 108, |
| 153, | 171, | 165, | 142, | 14, |
| 195, | 67, | 219, | 209, | 202, |
| 129, | 187, | 165, | 37, | 122, |
| 147, | 99, | 111, | 218, | 249, |
| 71, | 232, | 15, | 7, | 134, |
| 113, | 166, | 211, | 210, | 26, |
| 1, | 247, | 141, | 168, | 78, |
| 88, | 18, | 175, | 165, | 117, |
| 121, | 225, | 2, | 43, | 197, |
| 188, | 214, | 81, | 160, | 62, |
| 126, | 195, | 123, | 80, | 65, |
| 212, | 186, | 93, | 184, | 179, |
| 250, | 84, | 38, | 217, | 22, |
| 181, | 240, | 169, | 68, | 106, |
| 239, | 73, | 214, | 234, | 8, |
| 71, | 13, | 176, | 82, | 127. |

11. An encoding method of the LDPC code using a processor, comprising the following steps of: using the processor to divide the parity-check matrix H into two submatrixes H = [Hm Hp], wherein Hm is a submatrix with size of M × (N-M) and Hp is a submatrix with size of M × M, and computing Hp⁻¹ and Hp⁻¹Hm, wherein the parity-check matrix H is constructed by the following steps of: constructing a M_{B} × N_{B} base matrix B for an LDPC code with code rate R and code length N, M_{B} = M / K, NB = N / K, M = N (1-R), K is the expansion factor of the base matrix, K ∈ Φ, and Φ is the set of the common factors of M and N, selecting the number of '1' in each row and each column of the base matrix B, so that the row weight distribution and the column weight distribution of B meet a preset node degree distribution, selecting the position of '1' in each row and each column in the base matrix B, so that the M_{B} × M_{B} submatrix composed of the right M_{B} columns of B is full rank, expanding the base matrix B into a parity-check matrix H with size of M × N, replacing '0' in the base matrix B with a K × K all-'0' matrix Z, replacing '1' in the base matrix B with a K × K dimensional circulant permutation matrix P, wherein the row number i and the column number j of '1' in P meet j = (i+k) mod k, k is the offset of the circulant permutation matrix, and mod indicates the modulo operation, and selecting an offset for each K × K circulant permutation matrix P; using the processor to compute the 1 × M parity-check sequence p = m(Hp⁻¹Hm)^{T} according to the input 1 × (N-M) information sequence m; and combining the information sequence m with the parity-check sequence p into the 1 × N code word sequence c = [m p], and outputting the same.

12. The encoding method of the LDPC code according to claim 11, wherein the parity-check matrix H is constructed by expanding a 27 × 36 base matrix B, and the position of '1' in the base matrix B is specifically as follows:
| | | | | |
|---|---|---|---|---|
| 10, | 13, | 14, | 18, | |
| 0, | 1, | 3, | 16, | |
| 0, | 2, | 3, | 20, | |
| 2, | 6, | 8, | 10, | |
| 1, | 11, | 17, | 24, | |
| 0, | 5, | 9, | 21, | |
| 4, | 6, | 10, | 25, | |
| 2, | 20, | 22, | 26, | |
| 2, | 27, | 31, | 35, | |
| 1, | 2, | 16, | 19, | 22, |
| 1, | 2, | 21, | 29, | |
| 0, | 1, | 3, | 15, | |
| 0, | 4, | 18, | 35, | |
| 0, | 1, | 11, | 34, | |
| 9, | 17, | 19, | 33, | |
| 0, | 1, | 5, | 14, | |
| 0, | 5, | 7, | 13, | |
| 2, | 4, | 11, | 12, | |
| 2, | 7, | 8, | 32, | 34, |
| 0, | 3, | 6, | 12, | |
| 4, | 13, | 32, | 33, | |
| 1, | 7, | 29, | 30, | |
| 9, | 28, | 30, | 31, | |
| 1, | 2, | 8, | 28, | |
| 15, | 25, | 26, | 27, | |
| 1, | 2, | 5, | 23, | |
| 0, | 12, | 23, | 24. | |

13. The encoding method of the LDPC code according to claim 12, wherein the step of expanding the base matrix B into a parity-check matrix H with size of 6912 × 9216 comprises the following steps of: replacing '0' in the base matrix B with a 256 × 256 all- '0' matrix Z, and replacing '1' in the base matrix B with a 256 × 256 circulant permutation matrix P, wherein the row number i and the column number j of '1' in P meet j = (i+k) mod 256, k is the offset of the circulant permutation matrix, mod indicates the modulo operation, and the offset of the circulant permutation matrix P is specifically as follows:
| | | | | |
|---|---|---|---|---|
| 195, | 130, | 214, | 42, | |
| 79, | 98, | 59, | 149, | |
| 157, | 72, | 125, | 189, | |
| 150, | 252, | 7, | 227, | |
| 76, | 187, | 217, | 32, | |
| 110, | 225, | 111, | 113, | |
| 104, | 84, | 100, | 81, | |
| 161, | 47, | 248, | 97, | |
| 135, | 96, | 51, | 158, | |
| 242, | 147, | 54, | 178, | 145, |
| 202, | 74, | 175, | 236, | |
| 235, | 129, | 128, | 128, | |
| 194, | 44, | 247, | 130, | |
| 109, | 76, | 36, | 184, | |
| 129, | 155, | 248, | 222, | |
| 10, | 161, | 6, | 81, | |
| 73, | 44, | 206, | 72, | |
| 227, | 92, | 39, | 90, | |
| 113, | 50, | 160, | 190, | 12, |
| 7, | 202, | 178, | 167, | |
| 228, | 2, | 83, | 7, | |
| 115, | 119, | 180, | 171, | |
| 145, | 165, | 196, | 41, | |
| 47, | 133, | 75, | 3, | |
| 16, | 89, | 90, | 138, | |
| 253, | 57, | 198, | 130, | |
| 182, | 166, | 172, | 180; | |
dividing the parity-check matrix H into two submatrixes H = [Hm Hp], wherein Hm is a submatrix with size of 6912 × 2304 and Hp is a submatrix with size of 6912 × 6912, and computing Hp⁻¹ and Hp⁻¹Hm; computing the 1 × 6912 parity-check sequence p = m(Hp⁻¹Hm) ^{T} according to the input 1 × 2304 information sequence m; and combining the information sequence m with the parity-check sequence p into the 1 × 9216 dimensional code word sequence c = [m p], and outputting the same.

14. The encoding method of the LDPC code according to claim 11, wherein the parity-check matrix H is constructed by expanding a 24 × 36 base matrix B, and the position of '1' in the base matrix B is specifically as follows:
| | | | | |
|---|---|---|---|---|
| 1, | 8, | 11, | 29, | 32, |
| 2, | 3, | 9, | 28, | 32, |
| 1, | 2, | 3, | 4, | 23, |
| 0, | 3, | 17, | 24, | 27, |
| 1, | 3, | 10, | 15, | 22, |
| 0, | 1, | 2, | 5, | 19, |
| 2, | 6, | 9, | 19, | 21, |
| 0, | 3, | 10, | 11, | 14, |
| 0, | 3, | 14, | 16, | 18, |
| 0, | 3, | 5, | 12, | 16, |
| 0, | 3, | 6, | 11, | 12, |
| 2, | 12, | 27, | 33, | 35, |
| 2, | 15, | 24, | 26, | 29, |
| 7, | 9, | 21, | 25, | 28, |
| 1, | 3, | 14, | 25, | 34, |
| 7, | 15, | 16, | 30, | 31, |
| 0, | 10, | 17, | 22, | 23, |
| 0, | 1, | 19, | 20, | 35, |
| 2, | 3, | 6, | 18, | 34, |
| 1, | 2, | 8, | 13, | 17, |
| 1, | 4, | 7, | 13, | 20, |
| 0, | 5, | 13, | 31, | 33, |
| 1, | 2, | 4, | 8, | 26, |
| 0, | 1, | 2, | 18, | 30. |

15. The encoding method of the LDPC code according to claim 14, wherein the step of expanding the base matrix B into a parity-check matrix H with size of 6144 × 9216 comprises the following steps of: replacing '0' in the base matrix B with a 256 × 256 all- '0' matrix Z, and replacing '1' in the base matrix B with a 256 × 256 circulant permutation matrix P, wherein the row number i and the column number j of '1' in P meet j = (i+k) mod 256, k is the offset of the circulant permutation matrix, mod indicates the modulo operation, and the offset of the circulant permutation matrix P is specifically as follows:
| | | | | |
|---|---|---|---|---|
| 64, | 14, | 11, | 157, | 147, |
| 167, | 61, | 158, | 108, | 147, |
| 81, | 197, | 208, | 2, | 93, |
| 188, | 90, | 198, | 100, | 233, |
| 153, | 165, | 230, | 66, | 91, |
| 17, | 144, | 195, | 150, | 193, |
| 220, | 57, | 145, | 223, | 91, |
| 111, | 133, | 57, | 145, | 108, |
| 153, | 171, | 165, | 142, | 14, |
| 195, | 67, | 219, | 209, | 202, |
| 129, | 187, | 165, | 37, | 122, |
| 147, | 99, | 111, | 218, | 249, |
| 71, | 232, | 15, | 7, | 134, |
| 113, | 166, | 211, | 210, | 26, |
| 1, | 247, | 141, | 168, | 78, |
| 88, | 18, | 175, | 165, | 117, |
| 121, | 225, | 2, | 43, | 197, |
| 188, | 214, | 81, | 160, | 62, |
| 126, | 195, | 123, | 80, | 65, |
| 212, | 186, | 93, | 184, | 179, |
| 250, | 84, | 38, | 217, | 22, |
| 181, | 240, | 169, | 68, | 106, |
| 239, | 73, | 214, | 234, | 8, |
| 71, | 13, | 176, | 82, | 127; |
dividing the parity-check matrix H into two submatrixes H = [Hm Hp], wherein Hm is a submatrix with size of 6144 × 3072 and Hp is a submatrix with size of 6144 ×6144, and computing Hp⁻¹ and Hp⁻¹Hm; computing the 1 × 6144 parity-check sequence p = m(Hp⁻¹Hm) ^{T} according to the input 1 ×3072 information sequence m; and combining the information sequence m and the parity-check sequence p into the 1 × 9216 code word sequence c = [m p], and outputting the same.

16. An encoding apparatus of the LDPC code, comprising an encoding matrix storing module, a parity-check sequence computing module and a code word sequence generating module, wherein the encoding matrix storing module is used for storing the structure of the encoding matrix, dividing the parity-check matrix H with size of M × N into two submatrixes H = [Hm Hp], wherein Hm is a submatrix with size of M × (N-M) and Hp is a submatrix with size of M × M, the encoding matrix storing module is used for storing the structure of the matrix Hp⁻¹Hm, wherein the Hp⁻¹Hm has the block circulant structure and can be stored in the form of block, and the parity-check matrix H is constructed by the following steps of: constructing a M_{B} × N_{B} base matrix B for an LDPC code with code rate R and code length N, wherein M_{B} = M / K, NB = N / K, M = N (1-R), K is the expansion factor of the base matrix, K ∈ Φ, and Φ is the set of the common factors of M and N, selecting the number of '1' in each row and each column of the base matrix B, so that the row weight distribution and the column weight distribution of B meet a preset node degree distribution, selecting the position of '1' in each row and each column in the base matrix B, so that the M_{B} × M_{B} submatrix composed of the right M_{B} columns of B is full rank, expanding the base matrix B into a parity-check matrix H with size of M × N, replacing '0' in the base matrix B with a K × K all-'0' matrix Z, replacing '1' in the base matrix B with a K × K circulant permutation matrix P, wherein the row number i and the column number j of '1' in P meet j = (i+k) mod k, k is the offset of the circulant permutation matrix, mod indicates the modulo operation, and selecting an offset for each K × K circulant permutation matrix P; the parity-check sequence computing module is used for multiplying the input information sequence m by the matrix (Hp⁻¹Hm)^{T} to obtain the parity-check sequence p; and the code word sequence generating module is used for combining the information sequence m with the parity-check sequence p into the code word sequence c, and outputting the same.

17. The encoding apparatus of the LDPC code according to claim 16, wherein the parity-check matrix H is constructed by expanding a 27 × 36 base matrix B, and the position of '1' in the base matrix B is specifically as follows:
| | | | | |
|---|---|---|---|---|
| 10, | 13, | 14, | 18, | |
| 0, | 1, | 3, | 16, | |
| 0, | 2, | 3, | 20, | |
| 2, | 6, | 8, | 10, | |
| 1, | 11, | 17, | 24, | |
| 0, | 5, | 9, | 21, | |
| 4, | 6, | 10, | 25, | |
| 2, | 20, | 22, | 26, | |
| 2, | 27, | 31, | 35, | |
| 1, | 2, | 16, | 19, | 22, |
| 1, | 2, | 21, | 29, | |
| 0, | 1, | 3, | 15, | |
| 0, | 4, | 18, | 35, | |
| 0, | 1, | 11, | 34, | |
| 9, | 17, | 19, | 33, | |
| 0, | 1, | 5, | 14, | |
| 0, | 5, | 7, | 13, | |
| 2, | 4, | 11, | 12, | |
| 2, | 7, | 8, | 32, | 34, |
| 0, | 3, | 6, | 12, | |
| 4, | 13, | 32, | 33, | |
| 1, | 7, | 29, | 30, | |
| 9, | 28, | 30, | 31, | |
| 1, | 2, | 8, | 28, | |
| 15, | 25, | 26, | 27, | |
| 1, | 2, | 5, | 23, | |
| 0, | 12, | 23, | 24; | |
the step of expanding the base matrix B into the parity-check matrix H with size of 6912 × 9216 comprises the following steps of: replacing '0' in the base matrix B with a 256 × 256 all-'0' matrix Z, and replacing '1' in the base matrix B with a 256 × 256 circulant permutation matrix P, wherein the row number i and the column number j of '1' in P meet j = (i+k) mod 256, k is the offset of the circulant permutation matrix, mod indicates the modulo operation, and the offsets of the circulant permutation matrix P is specifically as follows:
| | | | | |
|---|---|---|---|---|
| 195, | 130, | 214, | 42, | |
| 79, | 98, | 59, | 149, | |
| 157, | 72, | 125, | 189, | |
| 150, | 252, | 7, | 227, | |
| 76, | 187, | 217, | 32, | |
| 110, | 225, | 111, | 113, | |
| 104, | 84, | 100, | 81, | |
| 161, | 47, | 248, | 97, | |
| 135, | 96, | 51, | 158, | |
| 242, | 147, | 54, | 178, | 145, |
| 202, | 74, | 175, | 236, | |
| 235, | 129, | 128, | 128, | |
| 194, | 44, | 247, | 130, | |
| 109, | 76, | 36, | 184, | |
| 129, | 155, | 248, | 222, | |
| 10, | 161, | 6, | 81, | |
| 73, | 44, | 206, | 72, | |
| 227, | 92, | 39, | 90, | |
| 113, | 50, | 160, | 190, | 12, |
| 7, | 202, | 178, | 167, | |
| 228, | 2, | 83, | 7, | |
| 115, | 119, | 180, | 171, | |
| 145, | 165, | 196, | 41, | |
| 47, | 133, | 75, | 3, | |
| 16, | 89, | 90, | 138, | |
| 253, | 57, | 198, | 130, | |
| 182, | 166, | 172, | 180; | |

18. The encoding apparatus of the LDPC code according to claim 16, wherein the parity-check matrix H is constructed by expanding a 24 × 36 base matrix B, and the position of '1' in the base matrix B is specifically as follows:
| | | | | |
|---|---|---|---|---|
| 1, | 8, | 11, | 29, | 32, |
| 2, | 3, | 9, | 28, | 32, |
| 1, | 2, | 3, | 4, | 23, |
| 0, | 3, | 17, | 24, | 27, |
| 1, | 3, | 10, | 15, | 22, |
| 0, | 1, | 2, | 5, | 19, |
| 2, | 6, | 9, | 19, | 21, |
| 0, | 3, | 10, | 11, | 14, |
| 0, | 3, | 14, | 16, | 18, |
| 0, | 3, | 5, | 12, | 16, |
| 0, | 3, | 6, | 11, | 12, |
| 2, | 12, | 27, | 33, | 35, |
| 2, | 15, | 24, | 26, | 29, |
| 7, | 9, | 21, | 25, | 28, |
| 1, | 3, | 14, | 25, | 34, |
| 7, | 15, | 16, | 30, | 31, |
| 0, | 10, | 17, | 22, | 23, |
| 0, | 1, | 19, | 20, | 35, |
| 2, | 3, | 6, | 18, | 34, |
| 1, | 2, | 8, | 13, | 17, |
| 1, | 4, | 7, | 13, | 20, |
| 0, | 5, | 13, | 31, | 33, |
| 1, | 2, | 4, | 8, | 26, |
| 0, | 1, | 2, | 18, | 30; |
the step of expanding the base matrix B into the parity-check matrix H with size of 6144 × 9216 comprises the following steps of: replacing '0' in the base matrix B with the a 256 × 256 all- '0' matrix Z, and replacing '1' in the base matrix B with a 256 × 256 circulant permutation matrix P, wherein the row number i and the column number j of '1' in P meet j = (i+k) mod 256, k is the offset of the circulant permutation matrix, mod indicates the modulo operation, and the offset of the circulant permutation matrix P is specifically as follows:
| | | | | |
|---|---|---|---|---|
| 64, | 14, | 11, | 157, | 147, |
| 167, | 61, | 158, | 108, | 147, |
| 81, | 197, | 208, | 2, | 93, |
| 188, | 90, | 198, | 100, | 233, |
| 153, | 165, | 230, | 66, | 91, |
| 17, | 144, | 195, | 150, | 193, |
| 220, | 57, | 145, | 223, | 91, |
| 111, | 133, | 57, | 145, | 108, |
| 153, | 171, | 165, | 142, | 14, |
| 195, | 67, | 219, | 209, | 202, |
| 129, | 187, | 165, | 37, | 122, |
| 147, | 99, | 111, | 218, | 249, |
| 71, | 232, | 15, | 7, | 134, |
| 113, | 166, | 211, | 210, | 26, |
| 1, | 247, | 141, | 168, | 78, |
| 88, | 18, | 175, | 165, | 117, |
| 121, | 225, | 2, | 43, | 197, |
| 188, | 214, | 81, | 160, | 62, |
| 126, | 195, | 123, | 80, | 65, |
| 212, | 186, | 93, | 184, | 179, |
| 250, | 84, | 38, | 217, | 22, |
| 181, | 240, | 169, | 68, | 106, |
| 239, | 73, | 214, | 234, | 8, |
| 71, | 13, | 176, | 82, | 127; |
dividing the parity-check matrix H into two submatrixes H = [Hm Hp], wherein Hm is the submatrix with size of 6144 × 3072 and Hp is a submatrix with size of 6144 × 6144.
